# EUROPEAN PATENT APPLICATION

(11) **EP 4 779 638 A2**
(43) Date of publication of application: **22.07.2026**
(21) Application number: 25214577.6
(22) Date of filing: 10.11.2025
(51) Int. Cl.: G11C 7/10, G11C 7/22, G11C 8/12, G11C 8/10

(54) **MULTI-CHANNEL MEMORY DEVICE**

(30) Priority: 16.01.2025 KR 20250006677
(71) Applicant: SK hynix Inc., Bubal-eub Icheon-si Gyeonggi-do 17336 (KR)
(72) Inventor: MOON, Hong Ki, 17336 Icheon-si, Gyeonggi-do (KR); PARK, Min Su, 17336 Icheon-si, Gyeonggi-do (KR)
(74) Representative: Isarpatent

(57) **Abstract**

A memory device includes a first command address decoder configured to decode a first chip selection signal and first command address signals and generate first control signals, a second command address decoder configured to decode a second chip selection signal and second command address signals and generate second control signals during a multi-channel mode and configured to decode the second chip selection signal and the first command address signals and generate second control signals during a multi-rank mode, a first memory core including first memory cells and being controlled by the first control signals, and a second memory core including second memory cells and being controlled by the second control signals.

## Description

### BACKGROUND

### 1. Technical Field

Various embodiments of the present disclosure relate to a memory.

### 2. Related Art

As the demand for larger memory capacities increases, memory systems are increasingly being configured with a multi-rank structure. In the multi-rank structure, a plurality of ranks are independently distinguished within a single channel, which is an effective way to increase memory system capacity without adding more channels. This rank-based structure has the advantage of providing a larger memory capacity while maintaining cost efficiency in manufacturing.

Increasing the number of channels is also widely used to improve the performance of a memory system. Increasing the number of channels may increase the number of data paths that can operate in parallel, which leads to an increase in bandwidth. Therefore, it is important to balance the number of ranks and channels to optimize both performance and capacity of the memory system. An appropriate configuration allows for the optimal design of the memory system for a specific application.

### SUMMARY

In accordance with an embodiment of the present disclosure, a memory may include a first command address decoder configured to decode a first chip selection signal and first command address signals and generate first control signals; a second command address decoder configured to decode a second chip selection signal and second command address signals and generate second control signals during a multi-channel mode and configured to decode the second chip selection signal and the first command address signals and generate second control signals during a multi-rank mode; a first memory core including first memory cells and being controlled by the first control signals; and a second memory core including second memory cells and being controlled by the second control signals.

In accordance with an embodiment of the present disclosure, a memory may include a first command address decoder configured to decode a first chip selection signal and first command address signals and generate first control signals; a second command address decoder configured to decode a second chip selection signal and second command address signals and generate second control signals during a multi-channel mode; a first memory core including first memory cells and being controlled by the first control signals; and a second memory core including second memory cells, being controlled by the second control signals during the multi-channel mode, and being controlled by the first control signals during a single-rank mode.

In accordance with an embodiment of the present disclosure, a memory may include a first command address decoder configured to decode command address signals and a chip selection signal; a second command address decoder configured to decode at least some different signals from the first command address decoder; a first data transmission and reception (transmission/reception) circuit configured to transmit and receive data through first data terminals; a second data transmission/reception circuit configured to transmit and receive data through second data terminals; and a configuration mode setting circuit configured to control activation and deactivation of the second command address decoder and the second data transmission/reception circuit depending on an operation mode.

### BRIEF DESCRIPTION OF THE DRAWINGS

FIG. 1 is a block diagram illustrating a memory in accordance with an embodiment of the present disclosure.
FIG. 2 is a block diagram illustrating a configuration mode setting circuit illustrated in FIG. 1.
FIG. 3 is a diagram illustrating levels of selection signals and activation signals generated by a signal generation unit according to a set mode, illustrated in FIG. 2.
FIG. 4 is a diagram illustrating a coupling state when the memory illustrated in FIG. 1 is set to a multi-channel mode.
FIG. 5 is a diagram illustrating a coupling state when the memory illustrated in FIG. 1 is set to a multi-rank mode.
FIG. 6 is a diagram illustrating a coupling state when the memory illustrated in FIG. 1 is set to a single-rank mode.

### DETAILED DESCRIPTION

Various embodiments of the present disclosure are directed to technology of adjusting the number of channels and the number of ranks of a memory according to demand.

According to embodiments of the present disclosure, it is possible to adjust the number of channels and the number of ranks of a memory.

Hereinafter, various embodiments according to the technical spirit of the present disclosure are described below with reference to the accompanying drawings.

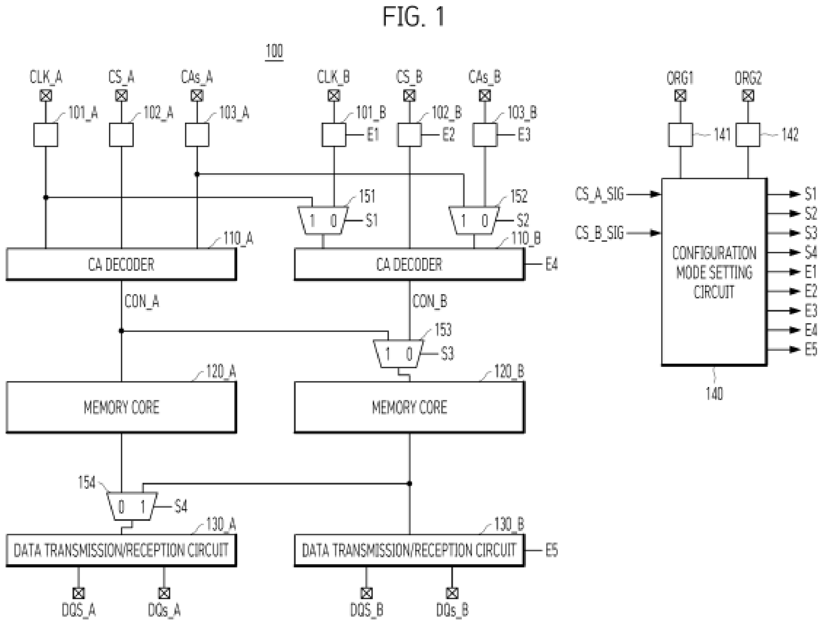

FIG. 1 is a block diagram illustrating a memory 100 in accordance with an embodiment of the present disclosure. By way of example, FIG. 1 illustrates a single memory die or chip.

Referring to FIG. 1, the memory 100 includes a first clock receiving circuit 101_A, a second clock receiving circuit 101_B, a first chip selection signal receiving circuit 102_A, a second chip selection signal receiving circuit 102_B, a first command address signal receiving circuit 103_A, a second command address signal receiving circuit 103_B, a first command address decoder 110_A, a second command address decoder 110_B, a first memory core 120_A, a second memory core 120_B, a first data transmission and reception (transmission/reception) circuit 130_A, a second data transmission/reception circuit 130_B, configuration signal receivers 141 and 142, a configuration mode setting circuit 140, and selection circuits 151, 152, 153 and 154.

The first clock receiving circuit 101_A receives a first clock of a first clock terminal CLK_A, and the first chip selection signal receiving circuit 102_A receives a first chip selection signal of a first chip selection signal terminal CS_A. The first command address signal receiving circuit 103_A receives first command address signals of first command address terminals CAs_A. The first command address signals may have multi bits, and the first command address terminals CAs_A may be formed in plural.

The second clock receiving circuit 101_B receives a second clock of a second clock terminal CLK_B, and the second chip selection signal receiving circuit 102_B receives a second chip selection signal of a second chip selection signal terminal CS_B. The second command address signal receiving circuit 103_B receives second command address signals of second command address terminals CAs_B. The second command address signals may have multi bits, and the second command address terminals CAs_B may be formed in plural.

The first command address (CA) decoder 110_A operates in synchronization with the first clock received by the first clock receiving circuit 101_A. The first command address decoder 110_A decodes the first chip selection signal received by the first chip selection signal receiving circuit 102_A and the first command address signals received by the first command address signal receiving circuit 103_A and generates first control signals CON_A. The first control signals CON_A may include a row address, a column address, a signal for instructing an active operation, a signal for instructing a precharge operation, a signal for instructing a refresh operation, a signal for instructing a read operation, and a signal for instructing a write operation.

The selection circuit 151 selects and outputs one of the first clock received by the first clock receiving circuit 101_A and the second clock received by the second clock receiving circuit 101_B in response to a first selection signal S1. The selection circuit 152 selects and outputs one of the first command address signals received by the first command address signal receiving circuit 103_A and the second command address signals received by the second command address signal receiving circuit 103_B in response to a second selection signal S2.

The second command address decoder 110_B operates in synchronization with the clock transmitted from the selection circuit 151. The second command address decoder 110_B decodes the second chip selection signal received by the second chip selection signal receiving circuit 102_B and the command address signals transmitted from the selection circuit 152 and generates second control signals CON_B. The second control signals CON_B may include a row address, a column address, a signal for instructing the active operation, a signal for instructing the precharge operation, a signal for instructing the refresh operation, a signal for instructing the read operation, and a signal for instructing the write operation.

The selection circuit 153 selects and outputs one of the first control signals CON_A and the second control signals CON_B in response to a third selection signal S3.

The memory cores 120_A and 120_B may store data. Each of the memory cores 120_A and 120_B may include a plurality of memory cells and configurations for writing and reading data to and from the memory cells. The first memory core 120_A may be controlled by the first control signals CON_A, and the second memory core 120_B may be controlled by the control signals selected by the selection circuit 153.

The selection circuit 154 may couple one of the first memory core 120_A and the second memory core 120_B to the first data transmission/reception circuit 130_A, in response to a fourth selection signal S4.

The first data transmission/reception circuit 130_A transmits and receives data of the memory core selected by the selection circuit 154 to and from first data terminals DQs_A. In addition, the first data transmission/reception circuit 130_A may transmit and receive a data strobe signal for strobing data to and from a first data strobe terminal DQS_A. The first data transmission/reception circuit 130_A may perform a serial-to-parallel conversion operation during the write operation and perform a parallel-to-serial conversion operation during the read operation. For example, when the number of first data terminals is 8, during the write operation, the first data transmission/reception circuit 130_A may receive 128 (=8*16) bits of data at Burst Length (BL) 16 through the 8 first data terminals DQs_A, convert the received data in a ratio of 8:128 in a serial-to-parallel manner and transmit the converted data to the memory core selected by the selection circuit 154. During the read operation, the first data transmission/reception circuit 130_A may convert the 128-bit data read from the memory core selected by the selection circuit 154 in a ratio of 128:8 in a parallel-to-serial manner and output the converted data at BL16 through the 8 first data terminals DQs_A.

The second data transmission/reception circuit 130_B transmits and receives data of the second memory core 120_B to and from second data terminals DQs_B. In addition, the second data transmission/reception circuit 130_B may transmit and receive a data strobe signal for strobing data to and from a second data strobe terminal DQS_B. During the write operation, the second data transmission/reception circuit 130_B may convert the data received from the second data terminals DQs_B in the serial-to-parallel manner and transmit the converted data to the second memory core 120_B. During the read operation, the second data transmission/reception circuit 130_B may convert the data read from the second memory core 120_B in the parallel-to-serial manner and transmit the converted data to the second data terminals DQs_B.

The configuration signal receivers 141 and 142 receive configuration signals of configuration signal terminals ORG1 and ORG2, respectively. The configuration signals may set the number of channels and the number of ranks of the memory 100. The configuration mode setting circuit 140 may set the number of channels and the number of ranks of the memory 100 using the configuration signals received by the configuration signal receivers 141 and 142. The configuration mode setting circuit 140 generates the selection signals S1 to S4 and activation signals E1 to E5. The number of channels and the number of ranks of the memory 100 may be changed depending on levels of the selection signals S1 to S4 and levels of the activation signals E1 to E5. The activation signals E1 to E5 are signals for reducing current consumption by deactivating unused configurations depending on a mode. A first activation signal E1 may control activation and deactivation of the second clock receiving circuit 101_B. A second activation signal E2 may control activation and deactivation of the second chip selection signal receiving circuit 102_B. A third activation signal E3 may control activation and deactivation of the second command address signal receiving circuit 103_B. A fourth activation signal E4 may control activation and deactivation of the second command address decoder 110_B. A fifth activation signal E5 may control activation and deactivation of the second data transmission/reception circuit 130_B. Because the generation of the selection signal S4 requires not only setting the mode but also checking the selected rank, the configuration mode setting circuit 140 may use chip selection signals CS_A_SIG and CS_B_SIG received by the chip selection signal receiving circuits 102_A and 102_B.

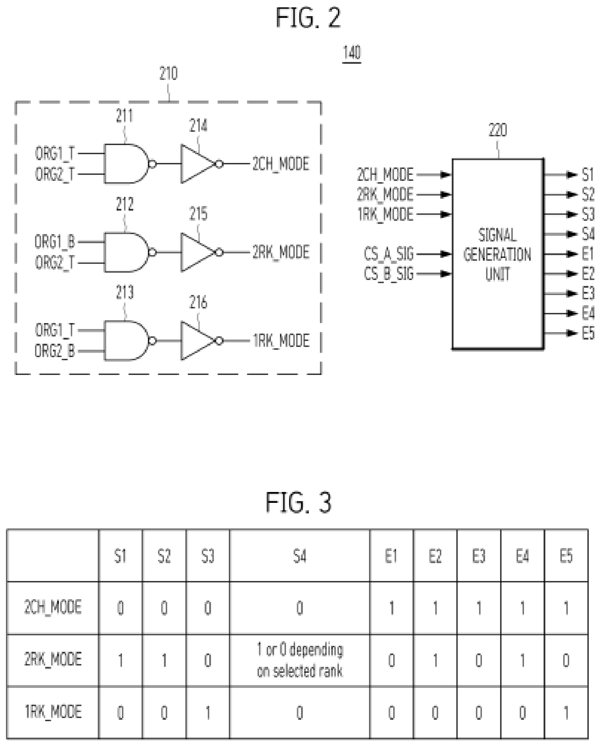

FIG. 2 is a block diagram illustrating the configuration mode setting circuit 140 illustrated in FIG. 1.

Referring to FIG. 2, the configuration mode setting circuit 140 includes a mode setting unit 210 and a signal generation unit 220.

The mode setting unit 210 decodes configuration signals ORG1_T, ORG1_B, ORG2_T and ORG2_B received by the configuration signal receivers 141 and 142 and generates mode signals 2CH_MODE, 2RK_MODE and 1RK_MODE. A first configuration signal ORG1_T is received from the configuration signal receiver 141, and an inverted first configuration signal ORG1_B is obtained by inverting the first configuration signal ORG1_T. A second configuration signal ORG2_T is received from the configuration signal receiver 142, and an inverted second configuration signal ORG2_B is obtained by inverting the second configuration signal ORG2_T. The mode setting unit 210 includes NAND gates 211 to 213 and inverters 214 to 216. When both the first configuration signal ORG1_T and the second configuration signal ORG2_T have a logic high level, i.e., (1, 1), a multi-channel mode signal 2CH_MODE may be activated to a logic high level "1". When the first configuration signal ORG1_T and the second configuration signal ORG2_T have a logic low level and a logic high level, respectively, i.e., (0, 1), a multi-rank mode signal 2RK_CODE may be activated to a logic high level "1". When the first configuration signal ORG1_T and the second configuration signal ORG2_T have a logic high level and a logic low level, respectively, i.e., (1, 0), a single-rank mode signal 1RK_MODE may be activated to a logic high level "1". As described above, the mode is set according to levels of the signals ORG1_T and ORG2_T received from the configuration signal terminals ORG1 and ORG2. Alternatively, the mode may also be set according to settings such as a mode register of the memory 100.

The signal generation unit 220 generates the selection signals S1 to S4 and the activation signals E1 to E5 depending on the set mode. FIG. 3 illustrates the levels of the selection signals S1 to S4 and activation signals E1 to E5 generated by the signal generation unit 220 depending on the set mode. When the multi-channel mode signal 2CH_MODE is activated, the signals S1, S2, S3, S4, E1, E2, E3, E4 and E5 may be generated to have logic levels as (0, 0, 0, 0, 1, 1, 1, 1, 1). When the multi-rank mode signal 2RK_MODE is activated, the signals S1, S2, S3, E1, E2, E3, E4 and E5 may be generated to have logic levels as (1, 1, 0, 0, 1, 0, 1, 0), and the selection signal S4 may be generated to have a logic level as "1" or "0" depending on the selection of a rank. When a rank corresponding to the first chip selection signal CS_A_SIG is selected, the selection signal S4 may be generated to have a logic level as "0". When a rank corresponding to the second chip selection signal CS_B_SIG is selected, the selection signal S4 may be generated to have a logic level as "1".

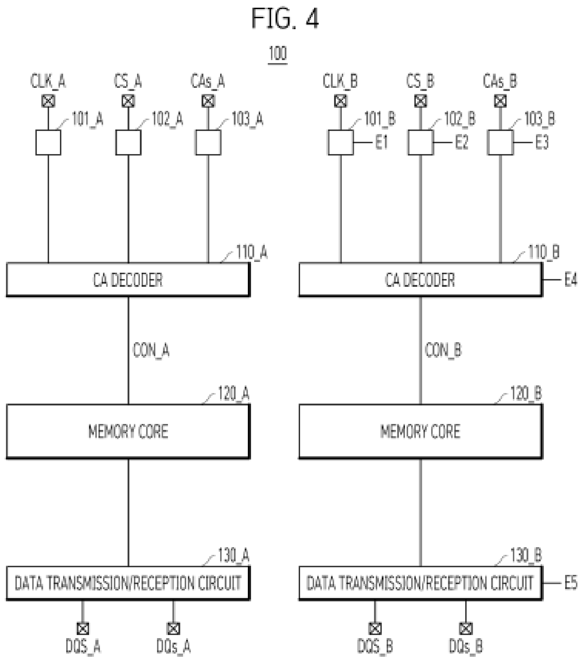

A method by which the configuration of the memory 100 changes depending on the levels of the signals S1, S2, S3, S4, E1, E2, E3, E4 and E5 generated by the signal generation unit 220 is described in detail with reference to FIGS. 4 to 6.

FIG. 4 is a diagram illustrating a coupling state when the memory 100 illustrated in FIG. 1 is set to a multi-channel mode. Herein, the configuration signal receivers 141 and 142, the configuration mode setting circuit 140 and the selection circuits 151, 152, 153 and 154 are omitted, and a state in which internal configurations of the memory 100 are coupled to one another by the selection circuits 151, 152, 153 and 154 is illustrated.

Referring to FIG. 4, during the multi-channel mode, the first command address decoder 110_A generates the first control signals CON_A using the signals received by the receiving circuits 101_A, 102_A and 103_A, and the first memory core 120_A is controlled by the first control signals CON_A. The data of the first memory core 120_A is transmitted and received by the first data transmission/reception circuit 130_A.

The second command address decoder 110_B generates the second control signals CON_B using the signals received by the receiving circuits 101_B, 102_B and 103_B, and the second memory core 120_B is controlled by the second control signals CON_B. The data of the second memory core 120_B is transmitted and received by the second data transmission/reception circuit 130_B.

That is, during the multi-channel mode, the configurations indicated as "A" operate as one channel, and the configurations indicated as "B" operate as another channel. That is, one memory 100 may operate as two channels.

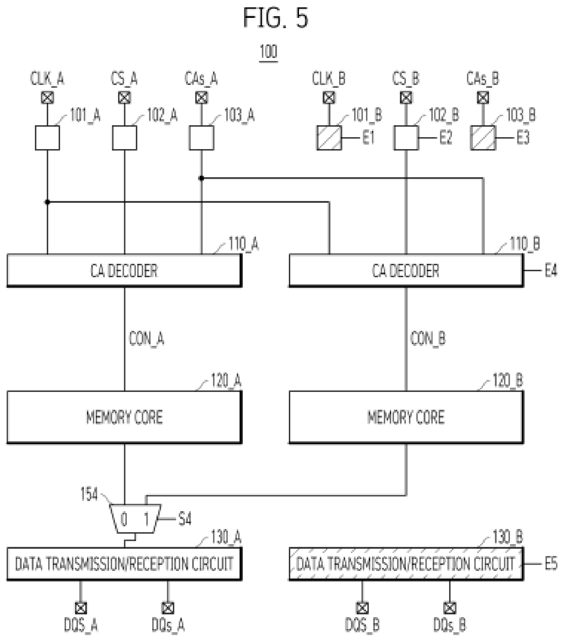

FIG. 5 is a diagram illustrating a coupling state when the memory 100 illustrated in FIG. 1 is set to a multi-rank mode. Herein, the configuration signal receivers 141 and 142, the configuration mode setting circuit 140 and the selection circuits 151, 152 and 153 are omitted, and a state in which internal configurations of the memory 100 are coupled to one another by the selection circuits 151, 152 and 153 is illustrated.

Referring to FIG. 5, shading (hatching) parts indicate the second clock receiving circuit 101_B, the second command address signal receiving circuit 103_B and the second data transmission/reception circuit 130_B, which are deactivated during the multi-rank mode.

During the multi-rank mode, the first command address decoder 110_A generates the first control signals CON_A using the signals received by the first clock receiving circuit 101_A, the first chip selection signal receiving circuit 102_A and the first command address signal receiving circuit 103_A. The second command address decoder 110_B generates the second control signals CON_B using the signals received from the first clock receiving circuit 101_A, the second chip selection signal receiving circuit 102_B and the first command address signal receiving circuit 103_A. That is, the first command address decoder 110_A and the second command address decoder 110_B receive the same command address signals and different chip selection signals for distinguishing the ranks.

The first memory core 120_A is controlled by the first control signals CON_A, and the second memory core 120_B is controlled by the second control signals CON_B. The data of the first memory core 120_A and the data of the second memory core 120_B are transmitted and received through the first data transmission/reception circuit 130_A, but the first data transmission/reception circuit 130_A transmits and receives data of a selected rank. That is, when the first memory core 120_A, which is the rank corresponding to the first chip selection signal CS_A_SIG, is selected, the first data transmission/reception circuit 130_A transmits and receives the data of the first memory core 120_A. When the second memory core, which is the rank corresponding to the second chip selection signal CS_B_SIG, is selected, the first data transmission/reception circuit 130_A transmits and receives the data of the second memory core 120_B.

During the multi-rank mode, the first memory core 120_A and the second memory core 120_B belong to the same channel, but operate as different ranks within the same channel. That is, one memory 100 may operate as two ranks.

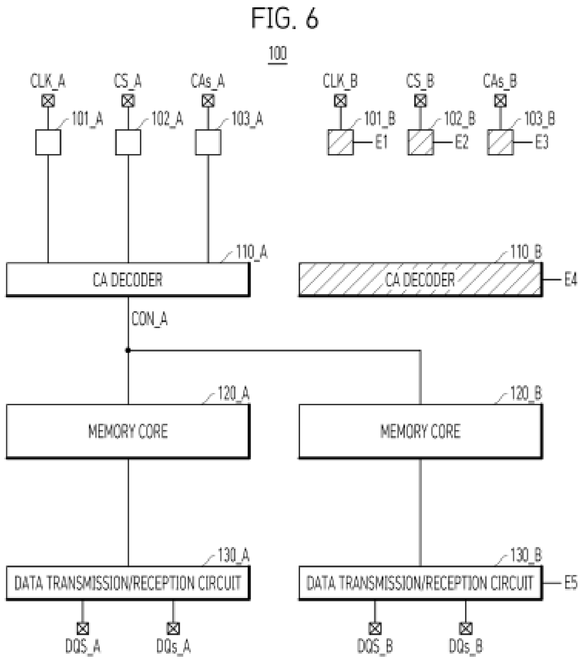

FIG. 6 is a diagram illustrating a coupling state when the memory 100 illustrated in FIG. 1 is set to a single-rank mode. Herein, the configuration signal receivers 141 and 142, the configuration mode setting circuit 140 and the selection circuits 151, 152, 153 and 154 are omitted, and a state in which internal configurations of the memory 100 are coupled to one another by the selection circuits 151, 152, 153 and 154 is illustrated.

Referring to FIG. 6, shading (hatching) parts indicate the second clock receiving circuit 101_B, the second chip selection signal receiving circuit 102_B, the second command address signal receiving circuit 103_B and the second command address decoder 110_B, which are deactivated during the single-rank mode.

During the single-rank mode, the first command address decoder 110_A generates the first control signals CON_A using the signals received from the receiving circuits 101_A, 102_A and 103_A. The first memory core 120_A and the second memory core 120_B are controlled by the first control signals CON_A. That is, the first memory core 120_A and the second memory core 120_B perform the same operation.

The data of the first memory core 120_A is transmitted and received through the first data transmission/reception circuit 130_A, and the data of the second memory core 120_B is transmitted and received through the second data transmission/reception circuit 130_B. Because the first memory core 120_A and the second memory core 120_B perform the write or read operation simultaneously, the first data transmission/reception circuit 130_A and the second data transmission/reception circuit 130_B receive or transmit the data simultaneously. That is, the number of bits of data inputted and outputted for each write operation and each read operation during the single-rank mode may be twice the number of bits of data inputted and outputted for each write operation and each read operation during the multi-channel mode and the multi-rank mode.

During the single-rank mode, the first memory core 120_A and the second memory core 120_B operate at the same rank. That is, one memory 100 may operate at one rank.

Although the technical scope of the present disclosure has been described above according to embodiments, this is only for describing the embodiments according to the technical concepts of the present disclosure, and the present invention is not limited to the above embodiments. Various embodiments may be applied by those skilled in the art, to which the present disclosure pertains, within the technical scope of the present disclosure. Furthermore, the embodiments may be combined to form additional embodiments.

## Claims

1. A memory device comprising:
a first command address decoder configured to decode a first chip selection signal and first command address signals, and generate first control signals;
a second command address decoder configured to decode a second chip selection signal and second command address signals, and generate second control signals during a multi-channel mode, and configured to decode the second chip selection signal and the first command address signals, and generate second control signals during a multi-rank mode;
a first memory core including first memory cells, the first memory core being controlled by the first control signals; and
a second memory core including second memory cells, the second memory core being controlled by the second control signals.

2. The memory device of claim 1, further comprising:
a first data transmission and reception (transmission/reception) circuit configured to transmit data, which is read from the first memory core, to first data terminals and receive data, which is to be written to the first memory core, from the first data terminals during the multi-channel mode, and configured to transmit data, which is read from a memory core selected from among the first memory core and the second memory core, to the first data terminals and receive data, which is to be written to the selected memory core, from the first data terminals during the multi-rank mode; and
a second data transmission/reception circuit configured to transmit data, which is read from the second memory core, to the second data terminals and receive data, which is to be written to the second memory core, from the second data terminals during the multi-channel mode.

3. The memory device of claim 2, wherein the second data transmission/reception circuit is deactivated during the multi-rank mode.

4. The memory device of claim 2, wherein the second memory core is controlled by the first control signals during a single-rank mode.

5. The memory device of claim 4, wherein
during the single-rank mode
the first data transmission/reception circuit transmits the data, which is read from the first memory core, to the first data terminals, and receives the data, which is to be written to the first memory core, from the first data terminals, and
the second data transmission/reception circuit transmits the data, which is read from the second memory core, to the second data terminals, and receives the data, which is to be written to the second memory core, from the second data terminals.

6. The memory device of claim 5, wherein the second command address decoder is deactivated during the single-rank mode.

7. The memory device of claim 2, wherein the first data transmission/reception circuit transmits and receives a first data strobe signal to and from a first data strobe terminal when the data is transmitted to and received from the first data terminals, and
wherein the second data transmission/reception circuit transmits and receives a second data strobe signal to and from a second data strobe terminal when the data is transmitted to and received from the second data terminals.

8. The memory device of claim 4, further comprising:
a first configuration terminal;
a second configuration terminal; and
a configuration mode setting circuit configured to set the multi-channel mode, the multi-rank mode and the single-rank mode depending on voltage levels of the first and second configuration terminals.

9. A memory device comprising:
a first command address decoder configured to decode a first chip selection signal and first command address signals, and generate first control signals;
a second command address decoder configured to decode a second chip selection signal and second command address signals, and generate second control signals during a multi-channel mode;
a first memory core including first memory cells, the first memory core being controlled by the first control signals; and
a second memory core including second memory cells, the second memory core controlled by the second control signals during the multi-channel mode, and the second memory core controlled by the first control signals during a single-rank mode.

10. The memory device of claim 9, further comprising:
a first data transmission/reception circuit configured to transmit data, which is read from the first memory core, to first data terminals and receive data, which is to be written to the first memory core, from the first data terminals; and
a second data transmission/reception circuit configured to transmit data, which is read from the second memory core, to second data terminals and receive data, which is to be written to the second memory core, from the second data terminals.

11. The memory device of claim 10, wherein the second command address decoder is deactivated during the single-rank mode.

12. The memory device of claim 10, wherein the first data transmission/reception circuit transmits and receives a first data strobe signal to and from a first data strobe terminal when the data is transmitted to and received from the first data terminals, and
the second data transmission/reception circuit transmits and receives a second data strobe signal to and from a second data strobe terminal when the data is transmitted to and received from the second data terminals.

13. The memory device of claim 10, further comprising:
one or more configuration terminals; and
a configuration mode setting circuit configured to set the multi-channel mode and the single-rank mode depending on voltage levels of the one or more configuration terminals.

14. A memory device comprising:
a first command address decoder configured to decode command address signals and a chip selection signal;
a second command address decoder configured to decode at least some different signals from the first command address decoder;
a first data transmission and reception (transmission/reception) circuit configured to transmit and receive data through first data terminals;
a second data transmission/reception circuit configured to transmit and receive data through second data terminals; and
a configuration mode setting circuit configured to control activation and deactivation of the second command address decoder and the second data transmission/reception circuit depending on an operation mode.

15. The memory device of claim 14, further comprising first and second memory cores each including a plurality of memory cells.
